**Europäisches Patentamt**

(19) **European Patent Office**

**Office européen des brevets**

(11) Veröffentlichungsnummer: **0 064 207**
**B1**

(12) # EUROPÄISCHE PATENTSCHRIFT

(45) Veröffentlichungstag der Patentschrift:
04.09.85

(51) Int. Cl.⁴: **C 08 L 67/00,** C 08 L 51/02,
C 08 F 265/04

(21) Anmeldenummer: **82103259.6**

(22) Anmeldetag: **19.04.82**

(54) **Alterungsbeständige, verarbeitungsstabile Mischungen hoher Zähigkeit auf Basis thermoplastischer Polyester.**

(30) Priorität: **29.04.81 DE 3117052**

(43) Veröffentlichungstag der Anmeldung:
**10.11.82 Patentblatt 82/45**

(45) Bekanntmachung des Hinweises auf die Patenterteilung:
**04.09.85 Patentblatt 85/36**

(84) Benannte Vertragsstaaten:
**DE FR GB IT NL SE**

(56) Entgegenhaltungen:
**EP - A - 0 029 931**
**EP - A - 0 050 262**
**FR - A - 2 354 370**
**GB - A - 2 040 958**
**GB - A - 2 045 775**
**US - A - 3 808 180**

(73) Patentinhaber: **BAYER AG, Konzernverwaltung RP Patentabteilung, D-5090 Leverkusen 1 Bayerwerk (DE)**

(72) Erfinder: **Binsack, Rudolf, Dr., Bethelstrasse 4a, D-4150 Krefeld (DE)**
Erfinder: **Lindner, Christian, Dr., Riehler Strasse 200, D-5000 Köln 60 (DE)**
Erfinder: **Rempel, Dieter, Dr., Max-Beckmann-Strasse 35, D-5090 Leverkusen 1 (DE)**
Erfinder: **Ott, Karl-Heinz, Dr., Paul-Klee-Strasse 54, D-5090 Leverkusen 1 (DE)**

**Beschreibung**

Die Erfindung betrifft Mischungen aus A) thermoplastischen Polyestern auf Basis aromatischer Dicarbonsäuren und B) gepfropften Acrylsäureestern, die als Formmassen, vornehmlich für den Spritzguss, geeignet sind.

Thermoplastische Polyester auf Basis aromatischer Dicarbonsäuren haben als Faserrohstoffe und auf dem Gebiet der Formmassen wegen ihrer wertvollen Eigenschaften, wie Steifigkeit, Härte, Abriebfestigkeit, dynamische und thermische Belastbarkeit, breite Anwendung gefunden. Dies gilt insbesondere für die teilkristallinen thermoplastischen Polyester, wie z.B. Polyethylenterephthalat, Poly-(butandiol-1,4-terephthalat) und Poly-(cyclohexan-1,4-bishydroxymethyl-terephthalat). Die Schlagzähigkeit dieser Polyester wird – insbesondere bei mehraxialer Belastung – nicht immer allen Anforderungen gerecht.

Aus der DE-OS 2 348 377 ist bekannt, dass man die Kerbschlagzähigkeit thermoplastischer Polyester durch Zusatz von 3 bis 30 Gew.% eines vernetzten Pfropfpolymerisats beträchtlich steigern kann. Als Pfropfpolymerisate besonders empfohlen werden mit Styrol und Methylmethacrylat gepfropfte vernetzte Polybutadiene. Die Pfropfpolymerisate sollen im Polyester möglichst homogen verteilt sein; die Teilchengrösse der Pfropfpolymerisate im Polyester-Formkörper beträgt laut DE-OS 2 348 377 etwa 0,02 bis 2 µm, vorzugsweise etwa 0,2 bis 1 µm.

Pfropfpolymerisate mit Polybutadien als Pfropfgrundlage altern bekanntlich aufgrund der reaktionsfähigen Doppelbindungen; Pfropfpolymerisate auf Polyacrylatbasis besitzen diesen Nachteil nicht. Versucht man allerdings, anstelle des gepfropften Polybutadiens der Mischungen gemäss DE-OS 2 348 377 gepfropfte Polyacrylsäureester einzusetzen, erhält man Polyester-Formkörper, welche wenigstens teilweise Polyacrylsäureester in agglomerierter Form enthalten, die überwiegend Teilchengrössen über 3 µm aufweisen. Eine derartige Agglomeration wirkt sich auf die mechanischen Eigenschaften der Polyester-Formkörper, z.B. deren Zähigkeit, negativ aus. Zwar kann man durch Einwirkung hoher Scherkräfte eine bessere Verteilung erreichen, riskiert damit allerdings einen teilweisen Abbau des Polyesters, was wiederum zu einer Verschlechterung der Eigenschaften führt.

Es ist ausserdem bekannt, dass in einer Polyestermatrix bereits homogen verteilter Kautschuk während der thermoplastischen Verarbeitung zur Agglomeration neigt, was bei Polyacrylatkautschuken ausgeprägter als bei Polybutadienkautschuken auftritt.

Es war also nicht nur Aufgabe der Erfindung, Mischungen von Polyacrylsäureestern geringer Agglomerisationsneigung und guter Verteilbarkeit in thermoplastischen Polyestern bereitzustellen; diese Teilchen sollten auch längere Verarbeitungszeiten bei erhöhter Temperatur – wie sie z.B. bei der Compoundierung im Extruder und bei der Spritzgussverarbeitung auftreten können –

ohne Agglomerisation zu Teilchen einer Grösse von über 3 µm überstehen; diese erwünschte Eigenschaft wird nachfolgend kurz als «Verarbeitungsstabilität» bezeichnet.

Aus den DE-OS 2 444 584 und 2 726 256 sind Mischungen thermoplastischer Polyester und Kautschuk-elastischer Pfropfpolymerisate auf Acrylatbasis bekannt. Sie zeigen jedoch nicht das gewünschte Eigenschaftsbild und lösen daher die Aufgabe der Erfindung nicht.

Überraschenderweise wurde nun gefunden, dass durch Pfropfpolymerisation von Monomeren – in Abwesenheit von Suspendiermittel – auf den vollständig gebrochenen und in Wasser aufgeschlämmten Latex eines Acrylatkautschuks ein pulverförmiges Pfropfpolymerisat entsteht, das mit üblichen Mitteln in thermoplastischen Polyestern zu einer aussergewöhnlich niedrigen Teilchengrösse verteilbar ist, die relativ unverändert auch längere Verarbeitungszeiten bei höherer Temperatur übersteht.

Der Begriff «aussergewöhnlich niedrige Teilchengrösse» meint, dass Anzahl, Form und Grösse der einzusetzenden Pfropfpolymerisatteilchen mit Anzahl, Form und Grösse der in den geschmolzenen thermoplastischen Polyester eingebrachten Pfropfpolymerisatteilchen auch nach dem Homogenisieren im wesentlichen noch übereinstimmen.

Gegenstand der Erfindung ist eine Mischung aus

A) 55 bis 99, vorzugsweise 70 bis 98, insbesondere 75 bis 97, Gew.%, bezogen auf die Summe der Komponenten A und B, thermoplastischer Polyester auf Basis aromatischer Dicarbonsäuren und

B) 1 bis 45, vorzugsweise 2 bis 30, insbesondere 3 bis 25, Gew.%, bezogen auf die Summe der Komponenten A und B, pulverförmiges Pfropfpolymerisat aus

a) 80 bis 98, vorzugsweise 85 bis 97, Gew.%, bezogen auf B, Acrylatkautschuk mit einer Glasübergangstemperatur unter 0°C als Pfropfgrundlage und

b) 2 bis 20, vorzugsweise 3 bis 15, Gew.%, bezogen auf B, mindestens eines polymerisierbaren ethylenisch ungesättigten Monomeren, dessen bzw. deren in Abwesenheit von (a) entstandenen Homo- bzw. Copolymerisate eine Glasübergangstemperatur über 25°C aufweisen, als Pfropfmonomere,

dadurch gekennzeichnet, dass das Pfropfpolymerisat B dadurch erhältlich ist, dass man Monomer (b) auf den vollständig gebrochenen und in Wasser aufgeschlämmten Latex von (a) in Abwesenheit von Suspendiermittel aufpfropft.

Das anfallende pulverförmige Pfropfpolymerisat B kann anschliessend getrocknet und im gewünschten Verhältnis mit Polyester A unter Einwirkung von Scherkräften so homogenisiert werden, dass die mittlere Teilchengrösse $d_{50}$ von B in A 0,05 bis 3, vorzugsweise 0,1 bis 2, insbesondere 0,2 bis 1 µm beträgt.

Die Bezeichnung «erhältlich» beinhaltet nach diesem Verfahren erhaltene Pfropfpolymerisate und Pfropfpolymerisate identischer Konstitution, die nach anderen Verfahren hergestellt worden sind.

Thermoplastische Polyester A im Sinne der Erfindung sind Reaktionsprodukte aus aromatischen Dicarbonsäuren oder ihren reaktionsfähigen Derivaten (z.B. Dimethylestern oder Anhydriden) und aliphatischen, cycloaliphatischen, araliphatischen oder aromatischen Diolen.

Bevorzugte Polyester A lassen sich aus Terephthalsäure (oder ihren reaktionsfähigen Derivaten) und Alkandiolen mit 2 bis 10 C-Atomen nach bekannten Methoden herstellen (Kunststoff-Handbuch, Bd. VIII, S. 695 ff, Carl Hanser Verlag, München 1973).

Bevorzugte Polyalkylenterephthalate A enthalten mindestens 80, vorzugsweise mindestens 90 Mol-%, bezogen auf die Dicarbonsäurekomponente, Terephthalsäurereste und mindestens 80, vorzugsweise mindestens 90 Mol-%, bezogen auf die Diolkomponente, Ethylenglykol- und/oder Butandiol-1,4-reste.

Die bevorzugten Polyalkylenterephthalate A können neben Terephthalsäureresten bis zu 20 Mol-% Reste anderer aromatischer Dicarbonsäuren mit 8–14 C-Atomen, aliphatischer Dicarbonsäuren mit 4 bis 12 C-Atomen enthalten, wie z.B. Reste von Phthalsäure, Isophthalsäure, Naphthalin-2,6-dicarbonsäure, Diphenyl-4,4'-dicarbonsäure, Bernstein-, Adipin-, Sebacinsäure, Azelainsäure und Cyclohexandiessigsäure.

Die bevorzugten Polyalkylenterephthalate A können neben Ethylenglykol- bzw. Butandiol-1,4-resten bis zu 20 Mol-% anderer aliphatischer Diole mit 3 bis 12 C-Atomen oder cycloaliphatischer Diole mit 6 bis 21 C-Atomen enthalten, z.B. Reste von Propandiol-1,3, 2-Ethylpropandiol-1,3, Neopentylglykol, Pentan-diol-1,5, Hexandiol-1,6, Cyclohexan-dimethanol-1,4, 3-Methylpentandiol-2,4, 2-Methylpentandiol-2,4, 2,2,4-Trimethylpentandiol-1,3 und -1,6, 2-Ethylhexandiol-1,3, 2,2-Diethylpropandiol-1,3, Hexandiol-2,5, 1,4-Di-($\beta$-hydroxyethoxy)-benzol, 2,2-Bis-(4-hydroxycyclohexyl)-propan, 2,4-Dihydroxy-1,1,3,3-tetramethyl-cyclobutan, 2,2-Bis-(3-$\beta$-hydroxyethoxyphenyl)-propan und 2,2-Bis-(4-hydroxypropoxyphenyl)-propan (DE-OS 2 407 674, 2 407 776, 2 715 932).

Die Polyalkylenterephthalate A können durch Einbau relativ kleiner Mengen 3- oder 4wertiger Alkohole oder 3- oder 4basischer Carbonsäuren, wie sie z.B. in der DE-OS 1 900 270 und der US-PS 2 692 744 beschrieben sind, verzweigt werden. Beispiele bevorzugter Verzweigungsmittel sind Trimesinsäure, Trimellithsäure, Trimethylolethan und -propan und Pentaerythrit. Es ist ratsam, nicht mehr als 1 Mol-% des Verzweigungsmittels, bezogen auf die Säurekomponente, zu verwenden.

Besonders bevorzugt sind Polyalkylenterephthalate A, die allein aus Terephthalsäure oder deren reaktionsfähigen Derivaten (z.B. deren Dialkylestern) und Ethylenglykol oder Butandiol-1,4 hergestellt worden sind.

Die als Komponente A vorzugsweise verwendeten Polyethylenterephthalate besitzen im allgemeinen eine Intrinsic-Viskosität von 0,4 bis 1,5 dl/g, vorzugsweise 0,5 bis 1,3 dl/g, insbesondere 0,6 bis 1,2 dl/g, und die als Komponente A verwendeten Polybutylenterephthalate besitzen im allgemeinen eine Intrinsic-Viskosität von 0,7 bis 1,5 dl/g, vorzugsweise 0,8 bis 1,3 dl/g, insbesondere 0,8 bis 1,05 dl/g, jeweils gemessen in Phenol/o-Dichlorbenzol (1:1 Gewichtsteile) bei 25°C.

Anstelle der Homo- oder Copolyester können auch die Mischungen dieser Polyester eingesetzt werden. Bevorzugte Mischungen bestehen aus

a) 1–99, vorzugsweise 10–80, insbesondere 30–60 Gew.% Polyethylenterephthalat und
b) 99–1, vorzugsweise 90–20, insbesondere 70–40 Gew.% Poly(1,4-butylenterephthalat).

Die Acrylkautschuke B (a) sind vorzugsweise Polymerisate aus Acrylsäurealkylestern, gegebenenfalls mit bis zu 40 Gew.% anderer polymerisierbarer ethylenisch ungesättigter Monomerer. Sofern die als Pfropfgrundlage (a) eingesetzten Acrylatkautschuke ihrerseits bereits Pfropfprodukte mit einem Dienkautschuk-Kern sind, wird zur Berechnung dieser Prozentangabe der Dienkautschuk-Kern nicht mitgezählt. Zu den bevorzugten polymerisierbaren Acrylsäureestern gehören $C_1$–$C_8$-Alkylester, beispielsweise Methyl-, Ethyl-, Butyl-, Octyl- und 2-Ethylhexylester; Halogenalkylester, vorzugsweise Halogen-$C_1$–$C_8$-alkylester, wie Chlorethylacrylat, und aromatische Ester wie Benzylacrylat und Phenethylacrylat. Sie können einzeln oder in Mischung eingesetzt werden.

Die Acrylatkautschuke (a) können unvernetzt, vernetzt, vorzugsweise partiell vernetzt sein.

Zur Vernetzung können Monomere mit mehr als einer polymerisierbaren Doppelbindung copolymerisiert werden. Bevorzugte Beispiele für vernetzende Monomere sind Ester ungesättigter Monocarbonsäuren mit 3 bis 8 C-Atomen und ungesättigter einwertiger Alkohole mit 3 bis 12 C-Atomen oder gesättigten Polyolen mit 2 bis 4 OH-Gruppen und 2 bis 20 C-Atomen, wie z.B. Ethylenglykoldimethacrylat, Allylmethacrylat; mehrfach ungesättigte heterocyclische Verbindungen, wie z.B. Trivinyl- und Triallylcyanurat und -isocyanurat, Tris-acryloyl-s-triazine, insbesondere Triallylcyanurat; polyfunktionelle Vinylverbindungen, wie Di- und Trivinylbenzole; aber auch Triallylphosphat und Diallylphthalat.

Bevorzugte vernetzende Monomere sind Allylmethacrylat, Ethylenglykoldimethacrylat, Diallylphthalat und heterocyclische Verbindungen, die mindestens drei ethylenisch ungesättigte Gruppen aufweisen.

Besonders bevorzugte vernetzende Monomere sind die cyclischen Monomeren Triallylcyanurat, Triallylisocyanurat, Trivinylcyanurat, Triacryloylhexahydro-s-triazin, Triallylbenzole.

Die Menge der vernetzenden Monomeren beträgt vorzugsweise 0,02 bis 5, insbesondere 0,05 bis 2, Gew.%, bezogen auf Pfropfgrundlage (a).

Bei cyclischen vernetzenden Monomeren mit mindestens drei ethylenisch ungesättigten Gruppen ist es vorteilhaft, die Menge auf <1 Gew.% der Pfropfgrundlage (a) zu beschränken.

Bevorzugte «andere» polymerisierbare ethylenisch ungesättigte Monomere, die neben den Acrylsäureestern gegebenenfalls zur Herstellung der Pfropfgrundlage (a) dienen können, sind z.B. Acrylnitril, Styrol, α-Methylstyrol, Acrylamide, Vinyl-$C_1$–$C_6$-alkylether. Bevorzugte Acrylatkautschuke als Pfropfgrundlage (a) sind Emulsionspolymerisate, die einen Gelgehalt von $\geqslant 60$ Gew.% aufweisen.

Der Gelgehalt der Pfropfgrundlage (a) wird bei 25°C in Dimethylformamid bestimmt (M. Hoffmann, H. Krömer, R. Kuhn, Polymeranalytik I und II, Georg Thieme Verlag, Stuttgart 1977).

Als Pfropfgrundlage (a) können auch solche Acrylatkautschuke verwendet werden, die als wässrige Emulsion (Latex) anfallen und deren Latexpartikel 1 bis 20 Gew.%, vorzugsweise 1 bis 10 Gew.%, bezogen auf (a), bereits in wässriger Emulsion aufgepfropfte Monomere enthalten, deren Homo- bzw. Copolymerisate Glastemperaturen 0°C aufweisen würden.

Bevorzugte derartige aufgepfropfte Monomere sind Alkylacrylate, Alkylmethacrylate, Styrol, Acrylnitril, α-Methylstyrol und/oder Vinylacetat.

Derartige Pfropfgrundlagen (a) werden z.B. durch Emulsionspolymerisation oder Emulsionspfropfpolymerisation hergestellt. Man kann sie aber auch so herstellen, dass man einen Acrylatkautschuk in Lösung oder Masse herstellt, dann die Pfropfmonomeren aufpfropft und anschliessend diese Kautschuke in eine wässrige Emulsion, die sich für weitere Pfropfverfahren eignet, überführt.

Acrylatkautschuke als Pfropfgrundlage (a) können auch Produkte sein, die einen vernetzten Dienkautschuk aus einem oder mehreren konjugierten Dienen, wie Polybutadien, oder ein Copolymerisat eines konjugierten Diens mit einem ethylenisch ungesättigten Monomer, wie Styrol und/oder Acrylnitril, als Kern enthalten.

Der Anteil des Polydien-Kerns in der Pfropfgrundlage (a) kann 0,1 bis 80, bevorzugt 10 bis 50, Gew.%, bezogen auf (a), betragen. Schale und Kern können unabhängig voneinander unvernetzt, teilvernetzt oder hochvernetzt sein.

Bevorzugte Pfropfgrundlagen (a) können also aus folgender Gruppe ausgewählt werden:

1. Polyacrylsäureesterpolymerisate und -copolymerisate,

2. Polyacrylsäureesterpolymerisate und -copolymerisate, die einen Dienkautschuk-Kern enthalten,

3. in wässriger Emulsion hergestellte Pfropfpolymerisate aus Polyacrylsäureesterpolymerisaten oder -copolymerisaten, die gegebenenfalls einen Dienkautschuk-Kern enthalten, und ethylenisch ungesättigten polymerisierbaren Monomeren.

Die Pfropfausbeute, d.h. der Quotient aus der Menge des aufgepfropften Monomeren (b) und der Menge des eingesetzten Pfropfmonomeren (b), beträgt in der Regel 20 bis 80 Gew.%. Die Bestimmung kann wie bei M. Hoffmann, H. Krömer, R. Kuhn, Polymeranalytik, Band 1, Georg Thieme Verlag, Stuttgart 1977, beschrieben, erfolgen.

Bevorzugte Pfropfmonomere (b) sind α-Methylstyrol, Styrol, Acrylnitril, Methylmethacrylat oder Mischungen dieser Monomeren. Bevorzugte Pfropfmonomer-Mischungen sind solche aus Styrol und Acrylnitril im Gewichtsverhältnis 90:10 bis 50:50.

Die pulverförmigen Pfropfpolymerisate B können wie folgt hergestellt werden:

Zunächst werden die Monomeren der Pfropfgrundlage (a) in an sich bekannter Weise in Gegenwart radikalbildender Initiatoren in Emulsion polymerisiert, so dass Teilchen mit einem mittleren Teilchendurchmesser $d_{50}$ von 0,05 bis 3 mm entstehen. Man kann das Monomerengemisch zu Beginn oder im Verlauf der Polymerisation kontinuierlich oder teilkontinuierlich in das Polymerisationssystem einbringen.

Soll als Pfropfgrundlage (a) ein vernetzter Acrylatkautschuk mit einem vernetzten Dienkautschuk als Kern eingesetzt werden, so stellt man zunächst den Dienkautschuk durch Emulsionspolymerisation eines konjugierten Diens in Latexform her. Dann werden ebenfalls in wässriger Emulsion die Pfropfmonomeren in dem Dienkautschuklatex emulgiert und in an sich bekannter Weise in Gegenwart radikalbildender Initiatoren polymerisiert. Die so entstehende Acrylatkautschukhülle kann durch Mitverwendung von vernetzenden Monomeren bereits bei der Herstellung vernetzt werden.

Bei dieser Herstellung einer bereits in Emulsion partiell gepfropften Pfropfgrundlage (a) muss die Bildung neuer Teilchen möglichst vollständig unterbunden werden. Ein Emulsionsstabilisator muss in einer zur Oberflächenbedeckung der Teilchen erforderlichen Menge vorhanden sein. Die Grösse dieser Teilchen ist durch die Reaktionsführung in weiten Grenzen zu variieren. Verwendet man als Polydien-Kern einen agglomerierten Latex, um grosse Teilchen zu erhalten, so können die Acrylatkautschukteilchen mehrere Dienkautschuk-Kerne enthalten. Man kann die Polymerisation des Acrylatkautschuks auch so führen, dass nebeneinander Acrylatkautschukteilchen ohne und mit Dienkautschuk-Kern erzeugt werden. Auch solche Mischungen können unter besonderen Umständen als Pfropfgrundlage (a) dienen.

Soll als Pfropfgrundlage (a) ein bereits gepfropfter Kautschuk dienen, so muss zunächst eine wässrige Aufschlämmung dieses gepfropften Kautschuks hergestellt werden.

Im Anschluss an die Herstellung der Pfropfgrundlage (a) wird diese Emulsion vollständig gebrochen bzw. koaguliert, z.B. durch Elektrolyten, Säuren, Basen, mechanische Einwirkung oder Temperatur. Bevorzugt arbeitet man mit wässrigen Lösungen von Säuren und/oder Salzen bei erhöhten Temperaturen, insbesondere bei Temperaturen zwischen 30°C und 100°C. Dadurch wird eine heterogene Aufschlämmung des Polymerisats in Form diskreter Polymerisatpartikel unterschiedlichster Form und Grösse in wässriger Phase erhalten. Die Partikelcharakteristiken lassen sich im Koagulationsmedium durch Variation der Fällungsparameter beeinflussen.

Durch Rühren dieser Aufschlämmungen wird das Verfahren günstig beeinflusst.

Nachdem die Polymerisataufschlämmung im wässrigen Koagulationsmedium erzeugt wurde, werden nun, vorzugsweise im Temperaturbereich von ca. 30–100°C, die Pfropfmonomeren (b), gegebenenfalls in Kombination mit Reglern, Radikalinitiatoren (insbesondere wasserlöslichen Persulfaten) oder Antioxidantien, in die bewegte Polymerisataufschlämmung eingebracht und radikalisch polymerisiert. Dabei ist der Zusatz von Suspendiermitteln zu vermeiden.

Anschliessend wird das Pfropfpolymerisat B isoliert, z.B. durch Filtration oder Zentrifugieren, und danach getrocknet. Das Verfahren eignet sich für dis-, halb- oder vollkontinuierliche Fahrweise.

Die Pfropfpolymerisate B sind nach Isolierung und Trocknung lagerbeständige, rieselfähige, nichtklebende Pulver, die in einfacher Weise zur Mischung mit den thermoplastischen Polyestern A mit üblichen Pulver-Förderaggretaten dosiert werden können. Ein besonderer Vorteil ist die ohne grosse Schereinwirkung hervorragende Dispergierfähigkeit der Pfropfprodukte B im geschmolzenen Polyester A.

Wenn die erfindungsgemäss zu verwendenden Pfropfpolymerisate B Anteile von Polymerisat enthalten, das durch Polymerisation nicht gepfropfter Anteile der Pfropfmonomeren (b) entstanden ist, soll unter «Pfropfpolymerisat B» – unabhängig vom Pfropfgrad – die Summe der Reaktionsprodukte verstanden werden, die durch Polymerisation der Pfropfmonomeren (b) in Anwesenheit der Pfropfgrundlage (a) entstehen.

Das pulverförmige Pfropfpolymerisat B hat eine mittlere Pulver-Teilchengrösse – bestimmt durch Siebanalyse – von 0,01 bis 10, vorzugsweise 0,05 bis 8, insbesondere 0,1 bis 4 mm.

Die mittlere Teilchengrösse $d_{50}$ ist der Durchmesser, oberhalb und unterhalb dessen jeweils 50 Gew.% der Teilchen liegen. Er kann bestimmt werden mittels Ultrazentrifugen-Messungen [W. Scholtan, H. Lange, Kolloid, Z. und Z. Polymere 250 (1972), 782—796] oder mittels Elektronenmikroskopie und anschliessende Teilchenauszählung [G. Kämpf, H. Schuster, Angew. Makromolekulare Chemie 14 (1970), 111–129] oder mittels Lichtstreuungsmessungen.

Der im Kennzeichen des Hauptanspruchs verwandte Begriff «in Abwesenheit von Suspendiermittel» bedeutet die Abwesenheit von Stoffen, die nach Art und Menge die Pfropfmonomeren (b) in der wässrigen Phase suspendieren könnten. Diese Definition schliesst die Anwesenheit von Stoffen nicht aus, die z.B. bei der Herstellung einer gepfropften Pfropfgrundlage (a) suspendierend gewirkt haben; in derartigen Fällen muss das Koagulations- oder Fällungsmittel, das zum Brechen des Latex (a) eingesetzt wird, in einer Menge zugesetzt werden, die die suspendierende Wirkung der in der Vorstufe eingesetzten Stoffe kompensiert; mit anderen Worten: Erfindungsgemäss muss darauf geachtet werden, dass die Pfropfmonomeren (b) in der wässrigen Phase keine (stabile) Emulsion ergeben.

Die erfindungsgemässen Polyester-Formmassen können übliche Additive, wie Gleit- und Entformungsmittel, Nukleiermittel, Stabilisatoren, Füll- und Verstärkungsstoffe, Flammschutzmittel sowie Farbstoffe enthalten.

Die gefüllten bzw. verstärkten Formmassen können bis zu 60, vorzugsweise 10 bis 50, Gew.%, bezogen auf die Formmasse, eines Füllstoffes und/oder Verstärkungsstoffes enthalten. Bevorzugte Verstärkungsstoffe sind Glasfasern. Bevorzugte Füllstoffe, die auch verstärkend wirken können, sind Glaskugeln, Glimmer, Silikate, Quarz, Talkum, Titandioxid, Wollastonit.

Die mit Flammschutzmitteln ausgerüsteten Polyester-Formmassen enthalten Flammschutzmittel in einer Konzentration von im allgemeinen weniger als 30 Gew.%, bezogen auf die Formmassen.

Es kommen alle bekannten Flammschutzmittel in Frage, wie z.B. Polyhalogendiphenyl, Polyhalogendiphenylether, Polyhalogenphthalsäure und ihre Derivate und Polyhalogenpolycarbonate, wobei die entsprechenden Bromverbindungen besonders wirksam sind. Ausserdem enthalten sie in der Regel einen Synergisten, wie z.B. Antimontrioxid.

Die Herstellung der Formmassen kann in den üblichen Mischaggregaten, wie Walzen, Knetern, Ein- und Mehrwellenextrudern, erfolgen. Besonders geeignet sind Doppelwellenextruder und Kneter.

Die Formmassen können auf den genannten Mischaggregaten hergestellt werden, indem die beiden Komponenten A und B gemeinsam aufgeschmolzen und homogenisiert werden oder indem das Pfropfpolymerisat B in die Schmelze des Polyesters A eingearbeitet wird.

Die Temperatur bei der Herstellung der Mischungen sollte mindestens 10°C und zweckmässig höchstens 80°C oberhalb des Schmelzpunktes des Polyesters A liegen.

Nach einem vorteilhaften Verfahren wird auf einem der genannten Mischaggregate in einem ersten Schritt eine Mischung mit einem niedrigeren als dem gewünschten Gehalt an Polyester A hergestellt und in einem zweiten Schritt mit weiterem Polyester A zu den erfindungsgemässen Mischungen verarbeitet.

Die erfindungsgemässen Mischungen zeichnen sich schon bei niedrigen Gehalten an Pfropfpolymerisat B durch eine erhebliche Verbesserung der Schlagzähigkeit bei mehraxialer Belastung auch bei Verwendung von Polyestern mit relativ niedrigem Molekulargewicht aus. Überraschend für die Mischungen ist auch die hohe Fliessnahtfestigkeit. Darüber hinaus zeichnen sie sich durch eine hohe Wärmeformbeständigkeit und eine überraschend hohe Beständigkeit bei Alterung in heisser Luft aus.

Entsprechend dem Eigenschaftsprofil können die erfindungsgemässen Mischungen daher überall im Spritzguss und Extrusionssektor dort eingesetzt werden, wo hohe mehraxiale Zähigkeit in Kombination mit hoher Wärmebeständigkeit und Heissluftbeständigkeit gefordert wird, z.B. bei Geräteteilen im Motorraum von Kraftfahrzeugen und bei temperaturbelasteten Haushaltsgeräten.

In den nachfolgenden Beispielen genannte Teile sind Gewichtsteile; Prozentangaben beziehen sich auf das Gewicht.

Beispiele

1. Herstellung der Pfropfgrundlage (a)

1.1 Herstellung eines Polybutadienlatex

In einem Reaktor wird unter Rühren eine Emulsion folgender Zusammensetzung bei 65°C bis praktisch zum vollständigen Monomerumsatz innerhalb von ca. 22 Stunden polymerisiert.

100 Teile Butadien,
1,8 Teile Na-Salz der disproportionierten Abietinsäure,
0,257 Teile Natriumhydroxid,
0,3 Teile n-Dodecylmercaptan,
1,029 Teile Na-Ethylendiamintetraacetat,
0,023 Teile Kaliumpersulfat und
176 Teile Wasser.

Es wird ein Latex erhalten, der Polybutadienteilchen eines mittleren Durchmessers ($d_{50}$) von 0,1 μm in einer Konzentration von ca. 36% enthält.

1.2 Herstellung von Acrylatkautschuk, der Polydienkerne enthält.

In einem Reaktor wird unter Rühren bei 63°C folgende Mischung vorgelegt:

200 Teile Latex 1.1,
5000 Teile Wasser,
14 Teile Kaliumpersulfat,
0,9124 Teile Triallylcyanurat und
399,09 Teile n-Butylacrylat.

Innerhalb von 5 Stunden werden bei 63°C folgende Mischungen in den Reaktor getrennt eindosiert:

Mischung 1:
90 Teile $C_{14}$–$C_{18}$-Alkylsulfonat-Na und
11 900 Teile Wasser.

Mischung 2:
23,09 Teile Triallylcyanurat und
10 101 Teile n-Butylacrylat.

Anschliessend lässt man 2 Stunden bei 65°C auspolymerisieren. Die gebildeten Polymerisate besitzen Gelgehalte von 85–95% und mittlere Teilchendurchmesser ($d_{50}$) von 0,5 μm (Polymerisat-Gehalt im Latex: 38%).

2. Herstellung der Pfropfpolymerisate B

2.1 Pfropfpolymerisat aus 90% Acrylatkautschuk 1.2 und 10% Methylmethacrylat

In einem Reaktor werden bei 70°C vorgelegt:

18 800 Teile Wasser und
245 Teile Bittersalz ($MgSO_4 \cdot xH_2O$).

Unter Rühren lässt man nun innerhalb von 2 Stunden 11 200 Teile Latex 1.2 in den Reaktor einlaufen.

Nach Beendigung dieses Zulaufs wird 1 Teil Kaliumpersulfat in den Reaktor gegeben und anschliessend werden 480 Teile Methylmethacrylat in 1 Stunde gleichmässig unter Rühren eindosiert. Anschliessend rührt man die Aufschlämmung 1 Stunde bei 90°C. Das Polymerisat kann nun isoliert werden (Pfropfpolymerisat K).

2.2 Pfropfpolymerisat aus 90% Acrylatkautschuk 1.2, 7,2% Styrol und 2,8% Acrylnitril

Beispiel 2.1 wird wiederholt; anstatt Methylmethacrylat wird eine Mischung aus 134 Teilen Acrylnitril und 346 Teilen Styrol in die Kautschukaufschlämmung eindosiert (Pfropfpolymerisat L).

3. Herstellung der Pfropfpolymerisate B, die Reste von sowohl in Emulsion als auch in Aufschlämmung gepfropften Monomeren (b) enthalten.

3.1 Herstellung der Emulsionspfropfpolymerisate

3.1.1 Emulsionspfropfpolymerisat aus 90% Acrylatkautschuk 1.2 und 10% Methylmethacrylat.

In einem Reaktor werden vorgelegt:

3296 Teile Latex 1.2,
1,5 Teile Kaliumpersulfat und
90 Teile Wasser.

Bei 65°C werden folgende Mischungen getrennt in den Reaktor eindosiert:

Mischung 1:
139 Teile Methylmethacrylat,

Mischung 2:
150 Teile Wasser und
4 Teile $C_{14}$–$C_{18}$-Alkylsulfonat-Na.

Anschliessend lässt man 4 Stunden bei 65°C auspolymerisieren (Pfropfpolymerisat M) (Polymerisat-Gehalt im Latex: 37,8%).

3.1.2 Emulsionspfropfpolymerisat aus 90% Acrylatkautschuk 1.2 und 7,2% Styrol und 2,8% Acrylnitril.

Beispiel 3.1.1 wird wiederholt; anstatt Methylmethacrylat wird eine Mischung aus 39 Teilen Acrylnitril und 100 Teilen Styrol als Mischung 1 eindosiert (Pfropfpolymerisat N).

3.2 Herstellung der Pfropfpolymerisate B aus den Emulsionspfropfpolymerisaten

3.2.1 Pfropfpolymerisat aus 80% Acrylatkautschuk und 20% Methylmethacrylat.
In einem Reaktor werden bei 70°C vorgelegt:
18 800 Teile Wasser und
240 Teile Bittersalz.

Unter Rühren lässt man nun innerhalb von 2 Stunden 11 200 Teile Latex 3.1.1 (Pfropfpolymerisat M) unter Rühren in den Reaktor einlaufen.
Nach Beendigung des Zulaufes wird 1 Teil Kaliumpersulfat in den Reaktor gegeben; anschliessend werden 529 Teile Methylmethacrylat in 1 Stunde gleichmässig unter Rühren eindosiert. Anschliessend rührt man die Aufschlämmung 1 Stunde bei 90°C. Dann wird das Polymerisat isoliert (Pfropfpolymerisat O).

3.2.2 Pfropfpolymerisat aus 80% Acrylkautschuk und 14,4% Styrol und 5,6% Acrylnitril.
Beispiel 3.2.1 wird wiederholt. Anstelle von Latex 3.1.1 wird das Latex 3.1.2 mit dem Pfropfpolymerisat N eingesetzt und anstelle von Methylmethacrylat wird mit einer Mischung aus

148 Teilen Acrylnitril und
381 Teilen Styrol

gearbeitet (Pfropfpolymerisat P).

4. Herstellung von Vergleichs-Pfropfpolymerisaten
Pfropfpolymerisat, Typ Q
Copolymerisat aus n-Butylacrylat und dem Acrylsäureester des Tricyclodecenylalkohols mit Pfropfästen aus 75% Styrol und 25% Acrylnitril (nach DE-OS 244 584).

Pfropfpolymerisat, Typ R
Copolymerisat aus einer Pfropfgrundlage aus
69,45 Teilen n-Butylacrylat,
0,35 Teilen 1,3-Butylendiacrylat und
0,28 Teilen Allylmethacrylat

und einer Pfropfhülle aus
19,95 Teilen Methylmethacrylat und
9,97 Teilen Allylmethacrylat
(nach DE-OS 2 726 256).

5. Herstellung der Mischungen
Auf einer kontinuierlich arbeitenden Zweiwellenmaschine der Fa. Werner und Pfleiderer wurden folgende Polyester aufgeschmolzen:

Typ S: Poly(butandiol-1,4-terephthalat) mit einer Intrinsic-Viskosität von 0,95 dl/g[1]

Typ T: Poly(butandiol-1,4-terephthalat) mit einer Intrinsic-Viskosität von 1,15 dl/g[1]

Typ U: Polyethylenterephthalat mit einer Intrinsic-Viskosität von 0,80 dl/g[1]

[1] gemessen im Ubbelohde-Viskosimeter in Phenol/o-Dichlorbenzol (Gewichtsverhältnis 1:1) bei 25°C.

Durch einen zweiten Einfüllstutzen wurde das Pfropfpolymerisat B unter Stickstoffatmosphäre in die Polyester-Schmelze eindosiert und in der Schmelze homogen dispergiert. (Es kann vorteilhaft sein, die Schmelze vor dem Austritt aus der Düse zu entgasen.) Die Zylinder-Temperaturen wurden so gewählt, dass eine Massetemperatur von 255°C bei Poly(butandiol-1,4)-terephthalat) und von 275°C bei Polyethylenterephthalat gewährleistet war. Der Schmelzstrang der erfindungsgemässen Mischungen wurde in Wasser abgekühlt, granuliert und getrocknet. Vom Granulat wurden auf einer üblichen Spritzgussmaschine Normkleinstäbe (nach DIN 53 453) und Platten von 3×60×60 mm bei folgenden Formtemperaturen verspritzt.
Poly(butandiol-1,4-terephthalat)-Mischung: 80°C, Polyethylenterephthalat-Mischung: 140°C.
Geprüft wurden die Schlagzähigkeit und Kerbschlagzähigkeit (nach DIN 53 453), Kugeldruckhärte (nach DIN 53 456), Wärmeformbeständigkeit nach Vicat (nach 53 460) sowie die Schlagzähigkeit bei mehraxialer Belastung im EKWA-Test (nach DIN 53 443, Blatt 2, Durchschlagung einer Platte von 3×60×60 mm mit einem Gewicht von 35 kg mit einem Durchstossdorn mit kugelförmiger Spitze, Durchmesser 20 mm, bei einer Fallhöhe von 1 m). Die Fliessnahtfestigkeit wurde im Zugversuch (nach DIN 53 455) an zweiseitig angespritzten Zugstäben geprüft. Die Ergebnisse sind in der Tabelle zusammengefasst.

| Beispiele | Zusammensetzung | | | | $a_k$[1] | $H_c$[2] | Vicat B | EKWA[3]-Test | |
| | Polyester | | Pfropfpolymerisat | | (kJ/m²) | (MPa) | (°C) | W. sec | Zahl der |
| | Typ | [%] | Typ | [%] | | | | | Zähbrüche [%] |
| --- | --- | --- | --- | --- | --- | --- | --- | --- | --- |
| 1 | S | 95 | O | 5 | 3,5 | 113 | 178 | 90 | 100 |
| 2 | S | 90 | O | 10 | 5,5 | 102 | 164 | 111 | 100 |
| 3 | S | 97 | P | 3 | 4,2 | 116 | 175 | 98 | 95 |
| 4 | S | 95 | P | 5 | 5,0 | 109 | 169 | 113 | 100 |
| 5 | S | 90 | P | 10 | 7,5 | 100 | 162 | 110 | 100 |
| 6 | S | 95 | K | 5 | 3,8 | 112 | 177 | 110 | 100 |
| 7 | S | 95 | L | 5 | 5,5 | 108 | 168 | 111 | 100 |
| 8 | T | 90 | L | 10 | 8,8 | 98 | 161 | 108 | 100 |
| 9 | T | 80 | P | 20 | 32 | 78 | 132 | 92 | 100 |
| 10 | T | 70 | P | 30 | n.g.[4] | 58 | 105 | 78 | 100 |

| Beispiele | Zusammensetzung | | | | $a_k$[1] (kJ/m$^2$) | $H_c$[2] (MPa) | Vicat B (°C) | EKWA[3]-Test | |
|---|---|---|---|---|---|---|---|---|---|
| | Polyester | | Pfropfpolymerisat | | | | | W. sec | Zahl der |
| | Typ | [%] | Typ | [%] | | | | | Zähbrüche [%] |
| 11 | T | 60 | P | 40 | n.g.[4] | 43 | 72 | 75 | 100 |
| 12 | U | 95 | P | 5 | 3,8 | 127 | 172 | 108 | 100 |
| 13 | U | 90 | P | 10 | 6,8 | 120 | 168 | 107 | 100 |
| Vergleichsbeispiele | | | | | | | | | |
| 14 | S | 100 | – | – | 2,3 | 123 | 182 | 15 | 0 |
| 15 | S | 95 | Q | 5 | 2,5 | 108 | 171 | 32 | 20 |
| 16 | S | 95 | R | 5 | 2,6 | 109 | 172 | 37 | 30 |

Der Schlagzähigkeitstest ergab für alle Proben aller Beispiele das Ergebnis «nicht gebrochen».
Die Fliessnahtfestigkeit[5] für alle Proben lag bei 100%.

1) Kerbschlagzähigkeit
2) Kugeldruckhärte
3) EKWA: Elektronische Kraft/Weg-Aufnahme

4) «nicht gebrochen»
5) $\dfrac{\text{Reissfestigkeit mit Fliessnaht} \cdot 100}{\text{Reissfestigkeit ohne Fliessnaht}}$

## Patentansprüche

1. Mischung aus

A) 55 bis 99 Gew.%, bezogen auf die Summe der Komponenten A und B, thermoplastische Polyester auf Basis aromatischer Dicarbonsäuren und

B) 1 bis 45 Gew.%, bezogen auf die Summe der Komponenten A und B, pulverförmiges Pfropfpolymerisat aus

a) 80 bis 98 Gew.%, bezogen auf B, Acrylatkautschuk mit einer Glasübergangstemperatur unter 0°C als Pfropfgrundlage und

b) 2 bis 20 Gew.%, bezogen auf B, mindestens eines polymerisierbaren ethylenisch ungesättigten Monomeren, dessen bzw. deren in Abwesenheit von A entstandenen Homo- bzw. Copolymerisate einer Glasübergangstemperatur über 25°C aufweisen, als Pfropfmonomere,

dadurch gekennzeichnet, dass das Pfropfpolymerisat B dadurch erhältlich ist, dass man Monomer (b) auf den vollständig gebrochenen und in Wasser aufgeschlämmten Latex von (a) in Abwesenheit von Suspendiermittel aufpfropft.

2. Mischung nach Anspruch 1, dadurch gekennzeichnet, dass die Mischung aus 70 bis 98 Gew.% Komponente A und 2 bis 30 Gew.% Komponente B, jeweils bezogen auf die Summe der Komponenten A und B, besteht.

3. Mischung nach Ansprüchen 1 und 2, dadurch gekennzeichnet, dass die Mischung aus 75 bis 97 Gew.% Komponente A und 3 bis 25 Gew.% Komponente B, jeweils bezogen auf die Summe der Komponenten A und B, besteht.

4. Mischung nach Ansprüchen 1–3, dadurch gekennzeichnet, dass das pulverförmige Pfropfpolymerisat aus 85 bis 97 Gew.% Pfropfgrundlage (a) und 3 bis 15 Gew.% Pfropfmonomeren (b), jeweils bezogen auf B, erhältlich ist.

5. Mischung nach Ansprüchen 1–4, dadurch gekennzeichnet, dass die mittlere Teilchengrösse $d_{50}$ von B in A 0,1 bis 2 μm beträgt.

6. Mischung nach Ansprüchen 1–5, dadurch gekennzeichnet, dass die mittlere Teilchengrösse $d_{50}$ von B in A 0,2 bis 1 μm beträgt.

7. Mischung nach Ansprüchen 1–6, dadurch gekennzeichnet, dass der Polyester A Polyethylenterephthalat und/oder Polybutylenterephthalat ist.

8. Mischung nach Ansprüchen 1–7, dadurch gekennzeichnet, dass die Pfropfgrundlage (a) einen Dienkautschuk-Kern enthält.

9. Mischung nach Ansprüchen 1–8, dadurch gekennzeichnet, dass die Pfropfgrundlage (a) ein Emulsionspfropfpolymerisat ist.

10. Mischung nach Ansprüchen 1–9, dadurch gekennzeichnet, dass sie glasfaserverstärkt ist.

## Claims

1. Mixture of

A) 55 to 99% by weight, based on the sum of components A and B, of thermoplastic polyesters based on aromatic dicarboxylic acids and

B) 1 to 45% by weight, based on the sum of components A and B, of a pulverulent graft polymer of

a) 80 to 98% by weight, based on B, of an acrylate rubber having a glass transition temperature of below 0°C as the graft base and

b) 2 to 20% by weight, based on B, of at least one polymerisable ethylenically unsaturated monomer, the homo- or copolymers of which, produced in the absence of A, have a glass transition temperature of above 25°C, as graft monomers,

characterised in that the graft polymer B is obtainable by grafting monomer (b) on the completely broken latex of (a) suspended in water, in the absence of a suspending agent.

2. Mixture according to Claim 1, characterised in that the mixture consists of 70 to 98% by weight of component A and 2 to 30% by weight of component B, in each case based on the sum of components A and B.

3. Mixture according to Claims 1 and 2, characterised in that the mixture consists of 75 to 97% by weight of component A and 3 to 25% by weight of component B, in each case based on the sum of components A and B.

4. Mixture according to Claims 1–3, characterised in that the pulverulent graft polymer is obtainable from 85 to 97% by weight of graft base (a) and 3 to 15% by weight of graft monomer (b), in each case based on B.

5. Mixture according to Claims 1–4, characterised in that the average particle size $d_{50}$ of 3 in A is 0.1 to 2 µm.

6. Mixture according to Claims 1–5, characterised in that the average particle size $d_{50}$ of B in A is 0.2 to 1 µm.

7. Mixture according to Claims 1–6, characterised in that the polyester A is polyethylene terephthalate and/or polybutylene terephthalate.

8. Mixture according to Claims 1–7, characterised in that the graft base (a) contains a diene rubber core.

9. Mixture according to Claims 1–8, characterised in that the graft base (a) is an emulsion graft polymer.

10. Mixture according to Claims 1–9, characterised in that it is reinforced with glass fibres.

## Revendications

1. Mélange de

A) 55 à 99% en poids, par rapport à la somme des composants A et B, de polyesters thermoplastiques à base d'acides dicarboxyliques aromatiques, et

B) 1 à 45% en poids, par rapport à la somme des composants A et B, de polymères greffés pulvérulents, formés de

a) 80 à 98% en poids, par rapport à B, de caoutchouc d'acrylate ayant une température de transition vitreuse inférieure à 0°C, comme base de greffage, et

b) 2 à 20% en poids, par rapport à B, d'au moins un monomère à insaturation éthylénique polymérisable, dont les homo- ou co-polymères, obtenus en l'absence de (a), présentent une température de transition vitreuse supérieure à 25°C, comme monomères de greffage,

mélange caractérisé en ce que le polymère greffé B peut être obtenu par greffage, en l'absence d'un agent de suspension, du monomère (b) sur le latex de (a) entièrement brisé et mis en suspension dans de l'eau.

2. Mélange selon la revendication 1, caractérisé en ce que le mélange consiste en 70 à 98% en poids du composant A et 2 à 30% en poids du composant B, chaque fois par rapport à la somme des composants A et B.

3. Mélange selon les revendications 1 et 2, caractérisé en ce que le mélange consiste en 75 à 97% en poids du composant A et en 3 à 25% en poids du composant B, chaque fois par rapport à la somme des composants A et B.

4. Mélange selon les revendications 1 à 3, caractérisé en ce que le polymère greffé pulvérulent peut être obtenu à partir de 85 à 97% en poids de la base de greffage (a) et de 3 à 15% en poids des monomères à greffer (b), chaque fois par rapport à B.

5. Mélange selon les revendications 1 à 4, caractérisé en ce que la grosseur moyenne des particules $d_{50}$ de B dans A est de 0,1 à 2 µm.

6. Mélange selon les revendications 1 à 5, caractérisé en ce que la grosseur moyenne des particules $d_{50}$ de B dans A est de 0,2 à 1 µm.

7. Mélange selon les revendications 1 à 6, caractérisé en ce que le polyester A est du poly(téréphtalate d'éthylène) et/ou du poly(téréphtalate de butylène).

8. Mélange selon les revendications 1 à 7, caractérisé en ce que la base de greffage (a) contient un noyau de caoutchouc de diène.

9. Mélange selon les revendications 1 à 8, caractérisé en ce que la base de greffage (a) est un polymère greffé obtenu en émulsion.

10. Mélange selon les revendications 1 à 9, caractérisé en ce qu'il comporte une armature de fibres de verre.